# EUROPEAN PATENT APPLICATION

(11) **EP 4 693 292 A1**
(43) Date of publication of application: **11.02.2026**
(21) Application number: 24924480.7
(22) Date of filing: 18.10.2024
(51) Int. Cl.: G11C 8/10

(54) **MEMORY**

(30) Priority: 18.02.2024 CN 202410181906
(71) Applicant: CXMT Corporation, Hefei City, Anhui Province 230601 (CN)
(72) Inventor: LI, Xiandong, Hefei, Anhui 230601 (CN); SHANG, Weibing, Hefei, Anhui 230601 (CN); HAN, Xiangyun, Hefei, Anhui 230601 (CN)
(74) Representative: Gulde & Partner
(86) International application number: PCT/CN2024/125705
(87) International publication number: WO 2025/171718

(57) **Abstract**

Embodiments of the present application relate to the field of memories and provide a memory. The memory includes a first phase decoder, a first memory section, and a second memory section. The first memory section and the second memory section are arranged in sequence in a first direction, where the first direction is an extension direction of bit lines. The first phase decoder is connected to the first memory section and outputs a plurality of first phase signals to the first memory section. The first phase decoder also outputs the plurality of first phase signals to the second memory section. In this way, at least the area of the memory can be reduced.

## Description

The present application claims priority to Chinese Patent Application No. 202410181906.1 filed with China National Intellectual Property Administration on February 18, 2024, and entitled "MEMORY", the content of which is incorporated herein by reference in its entirety.

### TECHNICAL FIELD

Embodiments of the present disclosure relate to the technical field of semiconductors, and in particular, to a memory.

### BACKGROUND

With the development of semiconductor technology, the demand for higher memory integration level and further size reduction has been steadily increasing. A dynamic random access memory (dynamic random access memory, DRAM) is a semiconductor memory that writes and reads data randomly at a high speed, and is widely used in data storage devices or apparatuses. In memories such as a DRAM, a row decoder and a column decoder are needed to decode an input address to obtain a specific word line or bit line address that needs to be activated in a memory array according to the input address.

In practical applications, the row decoder in the DRAM occupies a large area, exhibits high power consumption, and requires further area and power optimization.

### SUMMARY

Embodiments of the present application provide a memory, which is at least beneficial to solving the problems of current memories being too large in size and too high in power.

According to some embodiments of the present application, the embodiments of the present application provide a memory. The memory includes a first phase decoder, a first memory section, and a second memory section. The first memory section and the second memory section are arranged in sequence in a first direction, where the first direction is an extension direction of bit lines. The first phase decoder is connected to the first memory section and outputs a plurality of first phase signals to the first memory section. The first phase decoder also outputs the plurality of first phase signals to the second memory section.

The technical solutions provided according to the embodiments of the present application at least have the following advantages:

The embodiments of the present application provide a memory, in which the same phase decoder is shared by different memory sections, thereby reducing the areas of the row decoder and the memory while reducing the power consumption caused by the operation of excessive devices. In addition, with specific wiring and sharing methods of the phase decoders in different memory sections, the use of tracks is reduced, and the signal timing and driving effect are balanced while achieving area reduction, thereby improving operational reliability.

### BRIEF DESCRIPTION OF DRAWINGS

One or more embodiments are illustrated by images in corresponding drawings, and these exemplary explanations are not to be construed as limiting the embodiments. Unless expressly stated otherwise, the images in the drawings do not constitute a proportion limitation.
FIG. 1 is a schematic diagram of a layout of a memory according to an embodiment of the present disclosure;
FIG. 2 is a schematic block diagram of another layout of a memory according to an embodiment of the present disclosure;
FIG. 3 is a schematic block diagram of yet another layout of a memory according to an embodiment of the present disclosure;
FIG. 4 is a circuit diagram of a sub-word line driver according to an embodiment of the present disclosure;
FIG. 5 is a schematic block diagram of yet another layout of a memory according to an embodiment of the present disclosure;
FIG. 6 is a schematic block diagram of yet another layout of a memory according to an embodiment of the present disclosure;
FIG. 7 is a schematic diagram of a layout of a memory according to an embodiment of the present disclosure; and
FIG. 8 is a schematic diagram of another layout of a memory according to an embodiment of the present disclosure.

### DESCRIPTION OF EMBODIMENTS

Exemplary embodiments of the present disclosure will be described in detail below with reference to the drawings, such that those skilled in the art can easily practice the present disclosure. As those skilled in the art will recognize, the described embodiments may be modified in various ways, all without departing from the spirit or scope of the present disclosure. For example, the exemplary embodiments provided herein are considered to be capable of being combined in whole or in part for implementation. Specifically, an element described in a particular exemplary embodiment, even if not described in another exemplary embodiment, can be understood as a description relating to another exemplary embodiment, unless a contrary or contradictory description is provided therein.

Throughout this specification, when any part is referred to as being "connected" to another part, it includes the case where any part and another part are "indirectly connected" to each other with other parts interposed therebetween and the case where any part and another part are "directly connected" to each other. For example, it should be understood that when an element is referred to as being "connected" to another element, it can be directly connected to another element, or an intervening element may be present. Furthermore, "electrically connected" conceptually includes being physically connected and being physically disconnected.

It can be understood that when terms such as "first" and "second" are used to refer to an element, the element is not so limited. They may be used only for the purpose of distinguishing one element from another and may not limit the order or importance of the elements. In some cases, the first element may be termed the second element without departing from the scope of the claims set forth herein. Similarly, the second element may also be referred to as the first element.

The embodiments of the present application will be described in detail below with reference to the drawings. Those of ordinary skill in the art can understand that, in the embodiments of the present application, numerous technical details are set forth in order to enable readers to better understand the present application. However, the technical solutions claimed by the present application can also be implemented even without these technical details and the various changes and modifications based on the following embodiments.

Taking a DRAM as an example, it includes a data/address input/output buffer, a row decoder, a column decoder, and a memory array. The data/address input/output buffer belongs to the peripheral region circuit, while the row decoder, the column decoder, and the memory array belong to the array region circuit. The memory array mainly includes word lines, bit lines, and memory cells. In the memory array, the word lines extend in a row direction and the bit lines extend in a column direction, and the memory cells of the memory array are located at intersections of the word lines and the bit lines.

A memory cell is required to be addressed first before data is written into or read from the memory cell. During addressing, the corresponding row address signal and column address signal of the memory cell to be operated are first input into a row/column address buffer, and then a row decoder (row decoder, XDEC) decodes the signal to select a specific row address line, thereby activating a specific row address. Each row address line is connected to a plurality of column address lines and memory cells, and an additional sense amplifier (sense amplifier, SA) is required to amplify a weak activation signal on the column address lines for detection of this signal. Upon activating the row, the column address signal in the column address buffer is decoded by a column decoder (column decoder, YDEC) to determine the column address, and is amplified by the corresponding amplifier and then transmitted through the connected input/output (IO) lines, such that the memory cell is activated and available for read/write operation, thereby completing the addressing.

The row decoder includes a multi-stage row address decoder, a main word line driver (main word line driver, MWD), a phase decoder (phase decoder, PhDec), and the like. By decoding and driving input row address signals step by step, the row decoder generates an activation signal for activating a word line corresponding to a row address. The phase decoder decodes and drives a part of the input address signals (e.g., RA[2:0]) to generate a phase signal Fx, and inputs the phase signal to a sub-word line driver (sub-word line driver, SWD) to select a specific word line.

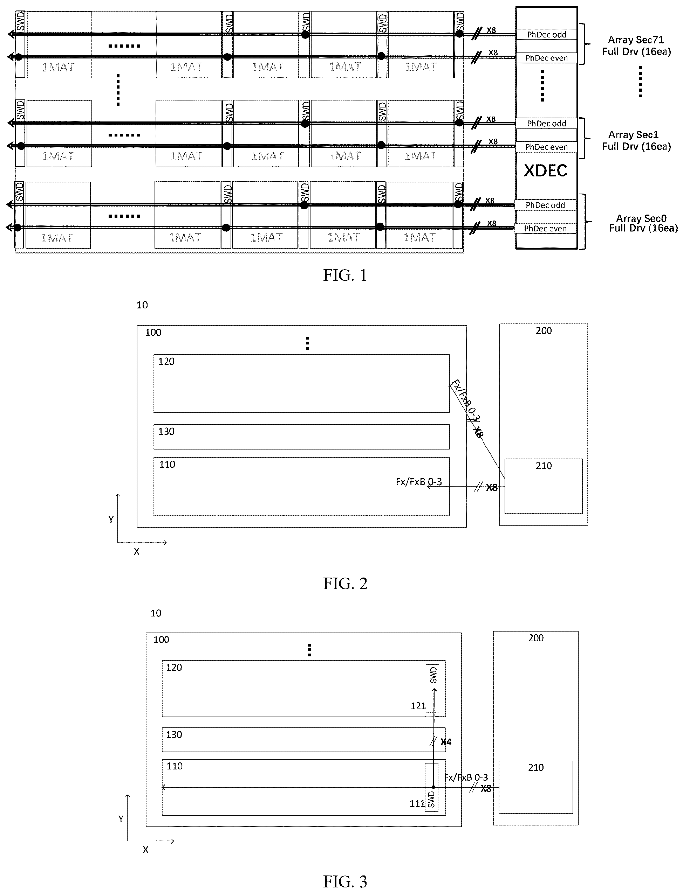

FIG. 1 shows a schematic structural diagram of a memory array driven by phase decoders. As shown in FIG. 1, the memory array includes a plurality of memory sections (shown as Array Sec in the figure), each memory section includes a plurality of memory blocks (shown as MAT in the figure), and the row decoder XDEC includes a plurality of phase decoders (shown as PhDec in the figure). Each memory section is driven by two phase decoders: an odd phase decoder (PhDec odd) and an even phase decoder (PhDec even). The odd phase decoder generates eight phase signals (shown as //X8 in the figure) to a sub-word line driver SWD on one side of the memory block MAT, and the even phase decoder generates eight phase signals to a sub-word line driver SWD on the other side of the memory block MAT (the black dots in the figure represent electrically connected nodes). The odd and even phase decoders generate odd and even phase signals to the memory sections to respectively drive the sub-word line drivers on both sides of the memory block MAT. Referring to FIG. 1, in the case that one memory block is decoded and driven by eight phase signals, the sub-word line drivers on both sides of the memory block each receive four phase signals and four inverted signals thereof. Therefore, the memory sections are in a one-to-one correspondence with the phase decoders, and each memory section requires eight phase decoders and 16 phase signal lines. Too many phase decoder circuits will occupy a significant area of the row decoder, leaving substantial room for optimization. In addition, 16 tracks are required to be allocated to the phase signals on each memory block, which will lead to greater wiring difficulty and spacing restrictions for other transverse signal lines. With the increasing demand for higher integration level, the burden caused by the area of the phase decoders and the tracks of the phase signal lines is particularly heavy.

The embodiments of the present application provide a memory, in which the same phase decoder is shared by different memory sections, thereby reducing the areas of the phase decoders and the row decoder while reducing the power consumption caused by the operation of excessive devices. In addition, with specific wiring and sharing methods of the phase decoders in different memory sections, the use of tracks is reduced, and the signal timing and driving effect are balanced while achieving area reduction, thereby improving operational reliability.

FIG. 2 is a block diagram of a memory according to an embodiment of the present disclosure. For ease of understanding, only a block diagram of a part of the circuit related to the present disclosure is shown in the figure.

Referring to FIG. 2, FIG. 2 shows a memory 10. The memory includes a first phase decoder 210, a first memory section 110, and a second memory section 120. The first memory section 110 and the second memory section 120 are arranged in sequence in a first direction Y, where the first direction is an extension direction of bit lines. The first phase decoder 210 is connected to the first memory section 110 and outputs a plurality of first phase signals Fx0-3 to the first memory section 110. The first phase decoder 210 also outputs the first phase signals Fx0-3 to the second memory section 120.

The memory includes a memory array 100 and a row decoder 200. The memory array includes a plurality of memory sections and a sense amplifier array (SA) arranged in the first direction Y. Each memory section includes a plurality of memory cells (not shown in the figure) arranged in an array, and a driving circuit (not shown in the figure) that drives the memory cells. The memory sections extend in a second direction X. The second direction X is perpendicular to the first direction Y and is an extension direction of word lines. FIG. 2 also shows a sense amplifier array 130. The sense amplifier array is located between the plurality of memory sections and configured to amplify the signals on the bit lines to assist in reading and writing when reading and writing the data of the memory cells. In the figure, only two memory sections 110, 120 and one sense amplifier array 130 are shown; however, the number of memory sections may be set according to the capacity requirement of the memory. The memory array may include a plurality of memory sections arranged in sequence in the first direction Y; a plurality of sense amplifier arrays may be provided, and each sense amplifier array may be disposed between two memory sections, which is not limited in the present disclosure.

The row decoder 200 may include a first phase decoder 210, a main word line driver MWD (not shown in the figure), a combinational logic circuit for multi-stage decoding (not shown in the figure), and the like. The row decoder is configured to receive a plurality of row address signals, and generate an activation signal for activating a word line corresponding to a row address by decoding and driving input row address signals step by step.

The phase decoder circuit may include a decoding and driving circuit. For example, the decoding and driving circuit decodes a part of bits of the input address to obtain a corresponding phase signal Fx and the inverted signal FxB thereof, drives the phase signal and the inverted signal and outputs the driven signals to the memory section, and combines the signals with the main word line signal MWL (not shown in Figure 2) output by the main word line driver to select and drive a corresponding word line. In the embodiments of the present disclosure, as an example, a complete phase decoder circuit decodes and drives three address signals RA0, RA1, RA2 to obtain eight phase signals Fx0-7 (in the figure, eight signal lines are represented by //X8) and the inverted signals FxB0-7 thereof. However, the number is not limited in the present disclosure. Since the phase signal and the inverted signal thereof always appear in the form of a signal pair, to avoid repetitive description, the signal pair is referred to as the phase signals in some places hereinafter without affecting clarity.

Referring to FIG. 2, the first phase decoder 210 is connected to the first memory section 110, and outputs a plurality of first phase signals Fx0-3 and the inverted signals FxB0-3 thereof to the first memory section 110. The first phase decoder 210 also outputs the first phase signals Fx0-3 and the inverted signals FxB0-3 thereof to the second memory section 120. Based on this, the first phase signals generated by the first phase decoder are shared by the first memory section and the second memory section, thereby saving the area of the phase decoder and further reducing the area of the row decoder and the memory. In addition, since the first memory section and the second memory section are adjacent to each other with the sense amplifier array interposed therebetween, the timing from the first phase decoder to the second memory section can also be secured.

Referring to FIG. 2, the first phase decoder 210 is located on one side of the first memory section 110 in the second direction X. The second direction is an extension direction of word lines, and specifically, the second direction X may be perpendicular to the first direction Y. Based on this arrangement, the first phase signals Fx0-3 generated by the first phase decoder and the inverted signals FxB0-3 thereof may be transmitted to the entire first memory section through first phase signal lines in the second direction X, enabling word line selection and driving for the entire first memory section without the need for track switching and bending.

The first phase decoder 210 may be directly connected to the second memory section and transmit the first phase signals Fx/FxB 0-3 to the second memory section through the signal lines, or may transmit the first phase signals Fx/FxB 0-3 to the second memory section via the signal lines in the second direction X after transmitting through the signal lines in the first direction Y within the row decoder. The present disclosure is not limited thereto. Signals generated by the first phase decoder 210 may also be transmitted over a certain distance through a part of the first phase signal lines in length, and then directly transmitted to the second memory section 120 by the first memory section 110 through the sense amplifier array 130 via the first direction Y, as shown in FIG. 3.

FIG. 3 shows a memory 10 according to an embodiment of the present disclosure. The first memory section 110 includes a first sub-word line driver 111; the first sub-word line driver 111 is configured to receive first sub-phase signals Fx0, Fx2 in the plurality of first phase signals Fx0-3, and perform word line driving according to the first sub-phase signals Fx0, Fx2. The second memory section 120 includes a second sub-word line driver 121; the second sub-word line driver 121 is configured to receive the first sub-phase signals Fx0, Fx2, and perform word line driving according to the first sub-phase signals Fx0, Fx2.

In this embodiment, there may be eight first phase signal lines for transmitting Fx0-3 and FxB0-3 separately. The first phase signals include the first sub-phase signals and the second sub-phase signals. The first sub-phase signals may be Fx0 and Fx2, and correspondingly, the second sub-phase signals may be Fx1 and Fx3. However, the present disclosure is not limited thereto, and the first sub-phase signals may also be Fx1 and Fx3, Fx0 and Fx1, Fx2 and Fx3, or other combinations. The first phase signal lines for transmitting the first sub-phase signals Fx0, Fx2 and the inverted signals FxB0, FxB2 thereof are electrically connected to the first sub-word line driver 111 directly towards a substrate direction through nodes and jumpers. At the same time, the first phase signal lines for transmitting the first sub-phase signals Fx0, Fx2 and the inverted signals FxB0, FxB2 thereof are electrically connected to the second sub-word line driver 121 through shared signal lines in the first direction Y. The substrate direction is perpendicular to the first direction and the second direction.

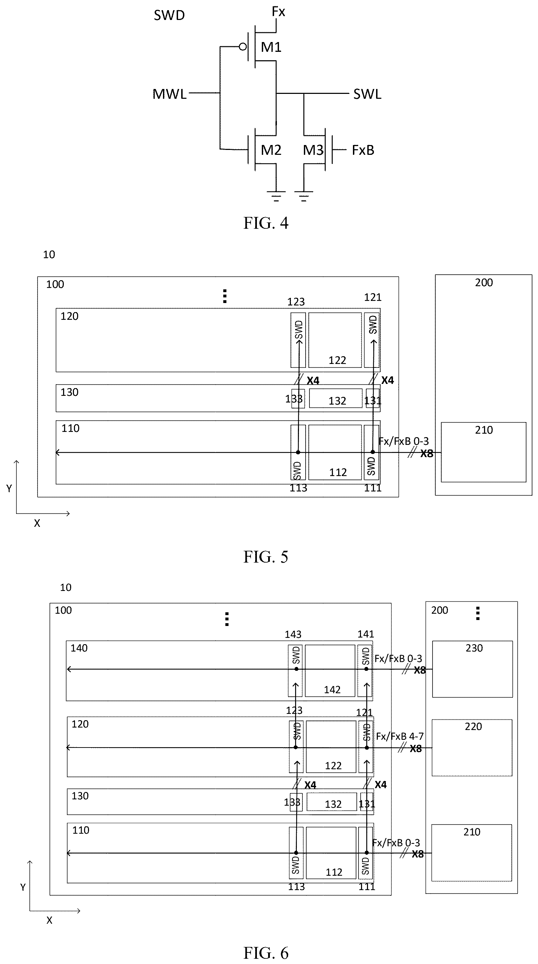

FIG. 4 shows a sub-word line driver circuit SWD according to an embodiment of the present disclosure. Referring to FIG. 4, the sub-word line driver circuit includes a first transistor M1, a second transistor M2, and a third transistor M3. A first terminal of the first transistor M1 receives a phase signal Fx, a second terminal of the first transistor is connected to a first terminal of the second transistor M2, and a control terminal of the first transistor M1 receives a main word line signal MWL output by a main word line driver MWD. The first terminal of the second transistor M2 is connected to the second terminal of the first transistor M1, a second terminal of the second transistor is connected to a ground potential or a negative potential, and a control terminal of the second transistor is connected to the control terminal of the first transistor M1. A first terminal of the third transistor M3 is connected to the second terminal of the first transistor M1 and the first terminal of the second transistor M2, and outputs a sub-word line signal SWL as an output terminal of the sub-word line driver. A second terminal of the third transistor M3 is connected to a ground potential or a negative potential. A control terminal of the third transistor M3 receives an inverted signal FxB corresponding to the phase signal. In some embodiments, the first transistor may be a PMOS transistor, and the second transistor and the third transistor may be NMOS transistors.

The sub-word line driver in the embodiments of the present disclosure may adopt the sub-word line driver circuit as shown in FIG. 4. However, the present disclosure is not limited thereto, and other types of sub-word line driver circuits may also be adopted.

FIG. 5 shows a memory 10 according to an embodiment of the present disclosure. Referring to FIG. 5, a first sense amplifier array 130 includes a plurality of first sense amplifiers 132 and a plurality of first sense amplifier driving circuits 131, 133. The first sense amplifier driving circuits 131, 133 are configured to drive the plurality of first sense amplifiers 132. The plurality of first sense amplifiers 132 and the plurality of first sense amplifier driving circuits 131, 133 are alternately arranged in the second direction X; the second direction X is perpendicular to the first direction Y. The first phase signal line includes a first sub-phase signal line and a second sub-phase signal line. A first shared signal line is connected to the first sub-phase signal line for transmitting the first sub-phase signals Fx0, Fx2; the first shared signal line is connected to the first sub-word line driver 111 and the second sub-word line driver 121; the first shared signal line extends in the first direction Y and passes through the sense amplifier driving circuits 131, 133, and a projection of the first shared signal line in the substrate direction falls into the first sub-word line driver and the second sub-word line driver. In FIG. 5, the substrate direction is a direction perpendicular to the first direction Y and the second direction X.

With this arrangement, since the first sub-word line driver and the second sub-word line driver both receive the first sub-phase signals through the first sub-phase signal line in the second direction, and the second sub-word line driver receives the first sub-phase signals through the first shared signal line in the first direction, the area of the phase decoder circuit is reduced, and the number of the phase signal lines above the first memory section is reduced by half. Thus, the number of tracks occupied by the phase signals is reduced, and wiring difficulty and size restrictions for the transverse signal lines are greatly reduced. At the same time, since the first sub-phase signals are directly transmitted to the second sub-word line driver through the first shared signal line, the wiring does not need to be arranged above the memory block by utilizing the tracks above the sense amplifier driving circuit, thereby saving more tracks for wirings of other key signals or an increase in the space between the phase signal lines and other key signal lines. In addition, four phase signal lines and the inverted signal lines thereof are uniformly arranged above each sense amplifier driving circuit, thereby improving the uniformity of timing and reducing wiring difficulty.

Although only one sense amplifier array is shown in the figure, the present disclosure is not limited thereto. The number of sense amplifier arrays, sense amplifiers, and sense amplifier driving circuits may be set correspondingly according to the number of memory sections, memory blocks, and memory cells.

In this embodiment, referring to FIG. 5, at least one memory block, such as the first memory block 112 or the second memory block 122, is included in the first memory section and/or the second memory section. The first memory block 112 and the second memory block 122 each may be driven by sub-word line drivers located on both sides thereof in the second direction X, and the two sub-word line drivers driving the same memory block receive different first phase signals. The second direction X is an extension direction of word lines, and specifically, the second direction X may be perpendicular to the first direction Y.

In this embodiment, referring to FIG. 5, the first memory section 110 further includes a first memory block 112 and a third sub-word line driver 113; the first sub-word line driver 111 and the third sub-word line driver 113 are located on different sides of the first memory block 112 in the second direction X, where the second direction X is an extension direction of word lines, and specifically, the second direction X may be perpendicular to the first direction Y; the third sub-word line driver 113 is configured to receive second sub-phase signals Fx1, Fx3 in the plurality of first phase signals Fx0-3, and perform word line driving within the first memory block 112 according to the second sub-phase signals Fx1, Fx3. The second memory section 120 further includes a second memory block 122 and a fourth sub-word line driver 123; the second sub-word line driver 121 and the fourth sub-word line driver 123 are located on different sides of the second memory block 122 in the second direction X; the fourth sub-word line driver 123 is configured to receive the second sub-phase signals Fx1, Fx3 in the plurality of first phase signals Fx0-3, and perform word line driving within the second memory block 122 according to the second sub-phase signals Fx1, Fx3.

The first phase decoder 210 generates the plurality of first phase signals Fx0-3, and the first phase signals include the first sub-phase signals Fx0, Fx2, and the second sub-phase signals Fx1, Fx3. The first memory section includes a plurality of memory blocks, and word lines of the first memory block 112 therein are co-driven by the first sub-word line driver 111 and the third sub-word line driver 113. Specifically, in this embodiment, the first sub-word line driver drives even-numbered word lines of the first memory block, and the third sub-word line driver drives odd-numbered word lines of the first memory block. At the same time, the second memory section includes a plurality of memory blocks, and word lines of the second memory block 122 therein are co-driven by the second sub-word line driver 121 and the fourth sub-word line driver 123. Specifically, in this embodiment, the second sub-word line driver drives even-numbered word lines of the second memory block, and the fourth sub-word line driver drives odd-numbered word lines of the second memory block. In addition, the second sub-phase signals are transmitted to the fourth sub-word line driver 123 from the third sub-word line driver through the second sub-phase signal line via the area above the second sense amplifier driving circuit 133. With this arrangement, the word lines of odd addresses and the word lines of even addresses of the memory blocks in each memory section are distinguished by the sub-word line drivers on both sides in the second direction X, forming a symmetrical driving structure, which is conducive to improving the driving capability of a single sub-word line driver to the word lines, balancing the layout and tracks, and enhancing the signal timing performance.

FIG. 6 shows a memory 10 according to an embodiment of the present disclosure. Referring to FIG. 6, the memory further includes a second phase decoder 220. The second phase decoder 220 is located on one side of the second memory section 120 in the second direction X, and the second phase decoder 220 is connected to the second memory section 120 and outputs a plurality of second phase signals Fx4-7 to the second memory section.

The second memory section receives the plurality of first phase signals Fx0-3 and the inverted signals thereof output by the first phase decoder and the plurality of second phase signals Fx4-7 and the inverted signals thereof output by the second phase decoder. Specifically, in this embodiment, the second phase decoder 220 is located on one side of the second memory section 120 in the second direction X. At least one memory block 122 is included in the second memory section 120, and the memory block 122 is driven by the sub-word line drivers 121, 123 located on both sides thereof in the second direction X. The sub-word line drivers 121 and 123 each receive the first phase signals Fx0-3 and the inverted signals thereof transmitted by the first shared signal line, and the second phase signals Fx4-7 and the inverted signals thereof directly transmitted by the second phase decoder.

With this arrangement, the phase signals received by the second memory section and the sub-word line drivers therein are partially from the second phase decoder and partially from the signals generated by the first phase decoder and transmitted by the first shared signal line. Thus, the area of the phase decoder required for driving the second memory section is saved, long-distance transverse tracks for transmitting the phase signals are avoided, the areas of the row decoder and the memory are reduced, the quality of the phase signals is improved, and the number of the transverse tracks is reduced by half, which greatly reduces the wiring difficulty and size restrictions for the transverse signal lines.

With continued reference to FIG. 6, the memory according to the embodiments of the present disclosure may further include a third memory section 140 and a third phase decoder 230. The third memory section 140 and the first memory section 110 are located on two opposite sides of the second memory section 120 in the first direction Y; the third memory section 140 is connected to the second phase decoder 220 and receives the plurality of second phase signals Fx4-7 and the inverted signals FxB4-7 thereof output by the second phase decoder 220; the third memory section 140 is connected to the third phase decoder 230 and receives the plurality of first phase signals Fx0-3 output by the third phase decoder 230. The third phase decoder is located on one side of the third memory section in the second direction. The third memory section 140 performs word line driving through the plurality of first phase signals Fx0-3 output by the third phase decoder 230 and the plurality of second phase decoding signals Fx4-7 output by the second phase decoder 220. Specifically, at least one memory block 142 is included in the third memory section 140, and the memory block 142 is driven by the sub-word line drivers 141, 143 located on both sides thereof in the second direction X. The sub-word line drivers 141 and 143 each receive the second phase signals Fx4-7 and the inverted signals thereof transmitted by the shared signal lines, and the first phase signals Fx0-3 and the inverted signals thereof directly transmitted by the third phase decoder 230.

The third memory section 140 may be connected to the second phase decoder 220 in a way shown in FIG. 6 or may be connected in other ways. For example, the third memory section may be directly connected to the second phase decoder 220 and transmit the second phase signals to the third memory section through the signal lines, or may transmit the first phase signals Fx/FxB 0-3 to the second memory section via the signal lines in the second direction X after transmitting through the signal lines in the first direction Y within the row decoder.

The first phase decoder 210 may be directly connected to the second memory section and transmit the first phase signals Fx/FxB 0-3 to the second memory section through the signal lines, or may transmit the first phase signals Fx/FxB 0-3 to the second memory section via the signal lines in the second direction X after transmitting through the signal lines in the first direction Y within the row decoder. However, the present disclosure is not limited thereto. Signals generated by the first phase decoder 210 may also be transmitted over a certain distance through a part of the first phase signal lines in length, and then directly transmitted to the second memory section 120 by the first memory section 110 through the sense amplifier array 130 via the first direction Y, as shown in FIG. 3.

Although FIG. 6 shows only three memory sections and three phase decoders, the present disclosure is not limited thereto. The memory may further include a fourth memory section, a fifth memory section, ..., and a fourth phase decoder, a fifth phase decoder, ...; the number of memory sections and phase decoders may be set according to the capacity of the memory. In the memories with different numbers of memory sections and phase decoders, different memory sections receive the phase decoding signals having the same source, that is, different memory sections share the phase decoders, thereby reducing the area ofthe row decoder.

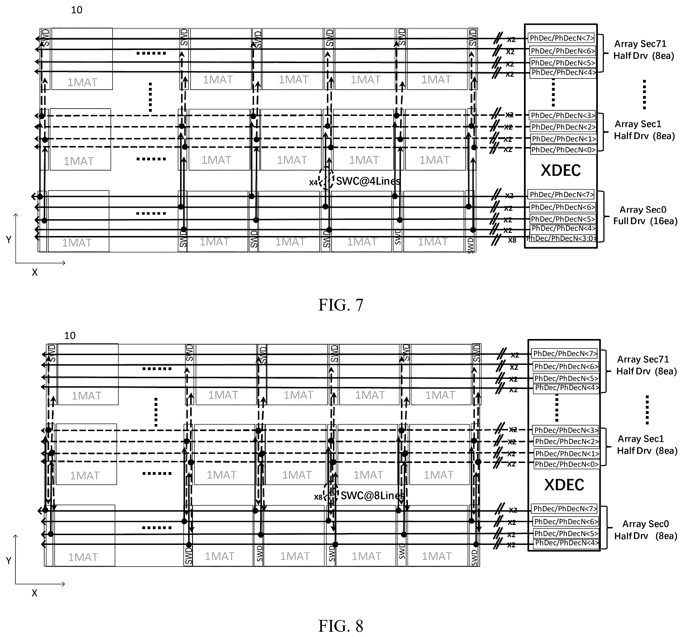

FIG. 7 shows a memory according to an embodiment of the present disclosure. Referring to FIG. 7, the memory includes a plurality of memory sections, and each memory section includes a plurality of memory blocks MAT. In some embodiments, each memory section includes eight memory blocks. Each memory block has two corresponding sub-word line drivers that drive the word lines. The two sub-word line drivers are located on both sides of the memory block in a word line direction (shown as the X direction) to drive the word lines in the memory block in an odd-even alternating manner. Specifically, the sub-word line driver on one side of the memory block may be configured only to drive the word lines of odd addresses, and the sub-word line driver on the other side may be configured only to drive the word lines of even addresses. In addition, one sub-word line driver may be shared by the memory blocks on both sides thereof to drive the memory blocks on both sides thereof. Specifically, one sub-word line driver may drive the word lines of odd addresses of the memory blocks on both sides thereof, or one sub-word line driver may drive the word lines of even addresses of the memory blocks on both sides thereof.

The capacity of each memory block may be 1 Kb, that is, each memory block may include 1000 memory cells. However, the present disclosure is not limited thereto, and in other embodiments, the capacity of each memory block may also be 512 bits, 2 Kb, or the like. Each memory block is provided with a corresponding sense amplifier array configured to amplify read-write signals of the memory block.

To avoid repetitive description, reference may be made to the relevant descriptions in FIGS. 2-6 for the structures of the phase decoders, the memory sections, the sub-word line drivers, and the like in FIG. 7 and the connection relationship and arrangement thereof as long as there is no conflict in the technical solutions. For clarity of illustration, SWD is only indicated at some positions in FIG. 7, but it can be understood that, in FIG. 7, the sub-word line drivers SWD and the memory blocks MAT are arranged in an array.

In other embodiments, one memory section may further include an error checking and correction (error checking and correction, ECC) memory block. The ECC memory block means that a memory cell in the memory block is configured to store ECC data. The capacity of the ECC memory block may be 0.5 times the capacity of a conventional memory block. The connection and positional relationship between the ECC memory block and the sub-word line driver may be the same as those of a conventional memory block.

Referring to FIG. 7, the memory sections and the phase decoders are arranged in a one-to-one correspondence. Each memory section may receive the phase decoding signals directly from a corresponding phase decoder and receive the shared phase decoding signals through the shared signal lines. Specifically, the first memory section Array Sec0 directly receives the first phase signals Fx/FxB<4>-<7> output by the first phase decoders PhDec/PhDecN<4>-<7> through the first phase signal lines. Specifically, one memory block in the first memory section is driven by the sub-word line drivers located on both sides thereof in the word line direction. The sub-word line driver on one side receives the even-numbered first phase signals and the inverted signals thereof Fx/FxB<4>, Fx/FxB<6>, and the sub-word line driver on the other side receives the odd-numbered first phase signals and the inverted signals thereof Fx/FxB<5>, Fx/FxB<7> (the connections are indicated by black dots in the figure). At the same time, the phase signals and the inverted signals thereof are transmitted to the second memory section Array Sec1 in a bit line direction (shown as the Y direction) through the shared signal lines. The shared signal lines are transmitted to the sub-word line drivers of the second memory section from the sub-word line drivers of the first memory section via four tracks occupied above the sense amplifier driving circuit SWC.

In the sub-word line drivers on both sides of one memory block of the second memory section, one sub-word line driver receives the even-numbered first phase signals and the inverted signals thereof Fx/FxB<4>, Fx/FxB<6> transmitted through the shared signal lines, and the even-numbered parts Fx/FxB<0>, Fx/FxB<2> in the second phase signals and the inverted signals thereof Fx/FxB<0>-<3> transmitted by the second phase decoders PhDec/PhDecN<0>-<3> directly through the second phase signal lines; the other sub-word line driver receives the odd-numbered first phase signals and the inverted signals thereof Fx/FxB<5>, Fx/FxB<7> transmitted through the shared signal lines, and the odd-numbered parts Fx/FxB<1>, Fx/FxB<3> in the second phase signals and the inverted signals thereof Fx/FxB<0>-<3> transmitted by the second phase decoders PhDec/PhDecN<0>-<3> directly through the second phase signal lines.

Based on the same principle, other memory sections may also share the phase decoders pairwise in this manner. Based on this, approximately half of the circuit area of the phase decoders in the row decoder can be saved, and the transverse decoding signal tracks are doubled. Referring to FIG. 7, one memory section only needs to generate the area of the phase decoder for four phase signals and the four inverted signals thereof (i.e., eight units in total, shown as 8ea), and the phase signals and the inverted signals thereof of one memory section only need eight tracks in total.

The first memory section Array Sec0 located at edges of the plurality of memory sections also needs to receive the second phase signals Fx/FxB<0>-<3> to fully drive the sub-word line drivers therein. Similarly, referring to FIG. 7, the first memory section Array Sec0 located at the edges also has another corresponding second phase decoders PhDec/PhDecN<0>-<3> (shown as PhDec/PhDecN<3:0>). The second phase decoders PhDec/PhDecN<0>-<3> generate the plurality of second phase signals Fx/FxB<0>-<3>, and transmit the signals directly to the first memory section Array Sec0 through the second phase signal lines, such that each sub-word line driver of the first memory section also fully receives the first phase signals Fx/FxB<4>-<7> and the second phase signals Fx/FxB<0>-<3>. Thus, the memory section located at the edges can also obtain the complete phase signals to drive all the sub-word line drivers by using all the word lines and memory cells.

For the last memory section Array Sec71 at the other edges of the plurality of memory sections, since there is no more memory section on the other side thereof in the bit line direction, the phase signals received from the corresponding phase decoder do not need to be shared, and thus, the sub-word line drivers do not need to be connected to the shared signal lines.

For the embodiment of Figure 7, the phase decoder corresponding to each memory section, except for the first memory section, only needs a decoding and driving circuit for eight phase signals (i.e., eight units, 8ea). The first memory section needs a 16ea phase decoder. This greatly reduces the area of the phase decoder circuit required for the entire memory array, compared to the need for a 16ea phase decoder for each memory section.

Referring to FIG. 8, the first memory section Array Sec0 located at edges of the plurality of memory sections also needs to receive the second phase signals Fx/FxB<0>-<3> to fully drive the sub-word line drivers therein. To further reduce the area, the first memory section is connected to the second phase decoders PhDec/PhDecN<0>-<3> correspondingly connected to the second memory section through the shared signal lines. Specifically, the first memory section Array Sec0 directly receives the first phase signals Fx/FxB<4>-<7> transmitted by corresponding first phase decoders PhDec/PhDecN<4>-<7> through the first phase signal lines in the word line direction (shown as the X direction). At the same time, the first memory section Array Sec0 is connected to the second memory section Array Sec1 through the shared signal lines in the bit line direction (shown as the Y direction) to receive the plurality of second phase signals Fx/FxB<0>-<3> generated by corresponding second phase decoders PhDec/PhDecN<0>-<3> and received by the second memory section through the second phase signal lines.

For other memory sections, the connection and phase signal receiving methods are the same as those in the embodiment of FIG. 7, which will not be repeated herein.

Based on this arrangement, for the first memory section located at the edges, only eight phase signal lines and the inverted signal lines thereof need to be arranged, thereby reducing the need for additional second phase decoders PhDec/PhDecN<0>-<3> for the first memory section and thus reducing the area to a greater extent.

In addition, since the phase signal lines on the second memory section Array Sec1 need to drive the sub-word line drivers of the first to third memory sections, and the load to be driven becomes heavy, in some other embodiments, the driving capability of the drive transistors in the second phase decoder corresponding to the second memory section Array Sec1 may be increased, for example, by adjusting the width-to-length ratio of the drive transistors, such that the width-to-length ratio of the drive transistors in the second phase decoder is larger than the width-to-length ratios of the drive transistors in other phase decoders, thereby increasing the driving capability of the drive transistors in the second phase decoder.

Those of ordinary skill in the art can understand that the foregoing implementations are specific embodiments of practicing the present application, while in practical applications, various changes can be made to the implementations in form and detail without departing from the spirit and scope of the present application. Any person skilled in the art can make respective changes and modifications without departing from the spirit and scope of the present application, and the protection scope of the present application is defined by the appended claims.

## Claims

1. A memory (10), comprising a first phase decoder (220), a first memory section (110), and a second memory section (120), wherein
the first memory section and the second memory section are arranged in sequence in a first direction (Y), wherein the first direction is an extension direction of bit lines;
the first phase decoder is connected to the first memory section and outputs a plurality of first phase signals (Fx0-3) to the first memory section; and
the first phase decoder also outputs the plurality of first phase signals to the second memory section.

2. The memory according to claim 1, wherein the first phase decoder is located on one side of the first memory section in a second direction (X),
wherein the second direction is an extension direction of word lines.

3. The memory according to claim 1, wherein the first memory section comprises a first sub-word line driver (111), wherein the first sub-word line driver is configured to receive first sub-phase signals (Fx0, Fx2) in the plurality of first phase signals, and perform word line driving according to the first sub-phase signals; and
the second memory section comprises a second sub-word line driver (121), wherein the second sub-word line driver is configured to receive the first sub-phase signals, and perform word line driving according to the first sub-phase signals.

4. The memory according to claim 3, wherein a first shared signal line is connected to the first sub-word line driver and the second sub-word line driver for transmitting the first sub-phase signals, wherein the first shared signal line extends in the first direction, and a projection of the first shared signal line in a substrate direction falls into the first sub-word line driver and the second sub-word line driver.

5. The memory according to claim 3 or 4, wherein the first memory section further comprises a first memory block (112) and a third sub-word line driver (113), wherein the first sub-word line driver and the third sub-word line driver are located on different sides of the first memory block in a second direction (X), the second direction being an extension direction of word lines; and
the third sub-word line driver is configured to receive second sub-phase signals (Fx1, Fx3) in the plurality of first phase signals, and perform word line driving within the first memory block according to the second sub-phase signals; and
the second memory section further comprises a second memory block (122) and a fourth sub-word line driver (123), wherein the second sub-word line driver and the fourth sub-word line driver are located on different sides of the second memory block in the second direction (X); and
the fourth sub-word line driver is configured to receive the second sub-phase signals, and perform word line driving within the second memory block according to the second sub-phase signals.

6. The memory according to any one of claims 1-5, wherein at least one memory block (112, 122) is comprised in the first memory section or the second memory section, wherein each memory block is driven by sub-word line drivers located on both sides thereof in the second direction (X), and the two sub-word line drivers driving the same memory block receive different first phase signals,
wherein the second direction is an extension direction of word lines.

7. The memory according to any one of claims 1-6, further comprising a second phase decoder (220), wherein the second phase decoder is connected to the second memory section through second phase signal lines and outputs a plurality of second phase signals to the second memory section.

8. The memory according to claim 7, wherein the second phase decoder is located on one side of the second memory section in the second direction; and
at least one memory block (122) is comprised in the second memory section, wherein each memory block is driven by sub-word line drivers located on both sides thereof in the second direction, and each of the sub-word line drivers receives the first phase signals and the second phase signals,
wherein the second direction is an extension direction of word lines.

9. The memory according to claim 7 or 8, further comprising a third memory section (140) and a third phase decoder (230), wherein the third memory section and the first memory section are located on two opposite sides of the second memory section in the first direction;
the third memory section is connected to the second phase decoder and receives the plurality of second phase signals output by the second phase decoder; and
the third memory section is connected to the third phase decoder and receives the plurality of first phase signals output by the third phase decoder.

10. The memory according to any one of claims 7-9, comprising a plurality of memory sections arranged in sequence in the first direction, wherein the first memory section (Array Sec0) is located at edges of the plurality of memory sections; and
the second phase decoder (PhDec/PhDecN<0>-<3>) is connected to the first memory section through the second phase signal lines and shared signal lines in the first direction and outputs the plurality of second phase signals (Fx/FxB<0>-<3>) to the first memory section.

11. The memory according to any one of claims 1-9, comprising a plurality of memory sections arranged in sequence in the first direction, wherein the first memory section (Array Sec0) is located at edges of the plurality of memory sections; and
further comprising the second phase decoder (PhDec/PhDecN<0>-<3>), wherein the second phase decoder is located on one side of the first memory section in the second direction, the second direction being an extension direction of word lines; and
the second phase decoder outputs the plurality of second phase signals to the first memory section through the second phase signal lines in the second direction.
